(19) **Europäisches Patentamt**
**European Patent Office**
**Office européen des brevets**

(11) **EP 2 015 456 A2**

(12) # EUROPEAN PATENT APPLICATION

(43) Date of publication:
**14.01.2009 Bulletin 2009/03**

(51) Int Cl.:
***H03M 7/06*** (2006.01)

(21) Application number: **08159887.2**

(22) Date of filing: **08.07.2008**

| | |
|---|---|
| (84) Designated Contracting States:<br>**AT BE BG CH CY CZ DE DK EE ES FI FR GB GR HR HU IE IS IT LI LT LU LV MC MT NL NO PL PT RO SE SI SK TR**<br>Designated Extension States:<br>**AL BA MK RS** | (71) Applicant: **Selex Communications S.P.A.**<br>**16151 Genova (IT)** |
| | (72) Inventor: **Liotta, Giuseppe**<br>**I-95047, PATERNO' (Catania) (IT)** |
| (30) Priority: **11.07.2007 IT TO20070508** | (74) Representative: **Deambrogi, Edgardo et al**<br>**Jacobacci & Partners S.p.A.**<br>**Corso Emilia, 8**<br>**10152 Torino (IT)** |

(54) **A computer-implemented method for encoding numeric data and a method for encoding data structures for transmission in a telecommunications system, based on said method of encoding numeric data.**

(57)    A method is described for encoding a numeric data element in a positional numbering system whose base elements are alphabetic characters which are represented according to the ASCII standard in binary coding, in which the value of the bit in position 6 of the binary code which represents all the characters representing the data element, with the exception of the character assigned to the least significant element, is set to a first predetermined binary value, and the value of the bit in position 6 of the binary code which represents the character assigned to the least significant element is set to the other binary value.

Also described arc a method of encoding and a method of decoding complex data structures comprising concatenated strings for transmission in the form of a sequence of characters in a telecommunications system, based on the provision of a header field of the string, associated with a useful data field for representing the sequence of characters of the string, in which the header field contains a stored numeric data element representing the number of characters making up the useful data field, which is encoded in the aforementioned positional numbering system.

EP 2 015 456 A2

**Description**

The present invention relates to the encoding of numeric data and the transmission of data structures in a telecommunications system, particularly in a telecommunications system based on an IP protocol.

Specifically, the invention relates to a method which can be implemented using a computer for encoding a numeric data element according to the preamble of Claim 1, to a method for encoding data structures according to the preamble of Claim 4, and to a method for decoding data structures according to the preamble of Claim 7.

In communications based on the IP protocol, in bandwidth-limited client-server applications for example, it is necessary to transfer data organized in more or less complex structures in the form of a unique character sequence. Examples of these structures are object serialization, "general-purpose" data structures organized hierarchically with an unspecified number of levels, and collections of strings.

For the transfer of these data structures, it is typically necessary to provide a system for encoding the data which is independent of the original nature of the data element, adapted to encode the structures in the form of a character sequence enabling the data element to be reconstructed efficiently in the original format at its destination.

The present state of the art is represented by tag-based technologies such as the XML language.

Unfortunately, the known encoding methods are characterized by a rigid syntax, which requires pre-processing of the data.

A rapid encoding system is desirable in certain fields of communication, such as satellite communication, or wherever optimization of the transmission bandwidth is required, and, if the data are alphanumeric, the system should enable the outcome of the encoding to be analysed by means of a simple text editor, rather than by using special debugging environments.

The object of the present invention is to provide a method for encoding numeric data in a computer, together with methods for encoding and decoding data structures respectively, which overcome the drawbacks of the known art.

A specific object of the invention is to provide an efficient string concatenation method for transmission in a telecommunications system.

According to the present invention, these objects are achieved by means of a method for encoding numeric data in a computer, having the characteristics claimed in Claim 1, a method for encoding data structures, having the characteristics claimed in Claim 4, and a method for decoding data structures, having the characteristics claimed in Claim 7.

Specific embodiments of the invention are described in the dependent claims.

Other subjects of the invention are a method for data transmission, as well as processing systems and a program or set of programs executable by said systems for the implementation of the claimed methods.

Briefly, the present invention is based on the principle of representing a numeric data element by means of a fixed-base positional numbering system in which the elements of the base are composed of alphabetic characters which can be represented in a computer in binary form according to ASCII coding, and preferably by the 26 characters of the English alphabet.

According to the invention, a numeric data element, in other words a numeric value or any expression which can be evaluated as a numeric value, can be represented by an expression including lower-case alphabetic characters, with the exception of the least significant element which is represented by an upper-case alphabetic character.

This advantageously enables a numeric data element to be represented in a self-consistent way, in other words in such a way that the dimension in terms of number of characters of the numeric data element is evident from the data element itself, without the a priori definition of the dimensions of a storage field for the data element and without the use of field delimiter characters.

The proposed numeric representation is more compact than hexadecimal or decimal representation, since it requires a smaller number of characters to represent the same numeric data element. This advantage becomes greater as the number to be represented increases.

Furthermore, since the number of characters used to represent a number is not fixed a priori, there are no unused characters, in other words no unused field bits.

The method for encoding data structures according to the invention is based on the concatenation of strings, in which, for each string, a data field is provided useful for the representation of a sequence of characters of the string, together with a header field indicating the number of characters making up the useful data field.

The header field of the string is of variable size and includes a numeric data element indicating the length of the string in characters according to the proposed method of representation.

Further characteristics and advantages of the invention will be disclosed more fully in the following detailed description of one embodiment thereof, provided by way of non-limiting example, with particular reference to the method of representing a numeric data element in a computer and to the method of encoding data structures for string concatenation.

According to the invention, a fixed-base positional numbering system is provided for the representation of a numeric data element in a computer, the elements of the base in this system being represented by alphabetic characters, and specifically by the English alphabetic characters, each of which is represented in binary coding according to the ASCII standard by one byte of data (using 7 bits according to the original standard or 8 bits according to the extended ASCII standard), and is identified by the decimal codes in the range from 65 to 90 in upper-case form and by the decimal codes in the range from 97 to 122 in lower-case form.

Preferably, all 26 alphabetic characters are used, thus creating a base 26 numbering system.

The following correspondence between the decimal base numeric value (or the same value in a binary, octal, or hexadecimal base) and the corresponding symbol in the base 26 numbering system is defined in a conversion matrix stored in a computer:

```
0      a, A
1      b, B
2      c, C
...    ...
25     z, Z
```

Thus, for example, the decimal numeric value 27 can be represented by the expression "bb" or "BB" in the proposed base 26.

It should be noted that, in the ASCII standard, a lower-case character is distinguished from the same character in upper case by the fact that the bit in position 6 of the binary code representing the character is set to "0" (for upper-case notation) or "1" (for lower-case notation).

The following rule is specified for the representation of a complete numeric data element according to the method of representation proposed by the invention: a numeric data element is represented by the symbols defined in the number base 26 in lower-case form, except for the least significant element which is used in upper-case form.

In order to represent a numeric data element stored in one of its memory registers or locations, a computer reads the numeric value or the expression indicating the numeric value of the data element, then converts the representation from the original base to the destination base proposed by the invention according to the well-known conversion rules, using the conversion matrix defined above, setting the value of the bit in position 6 of the binary code which represents all the data representation characters, except for the character assigned to the least significant element, to a first predetermined binary value, for example the value "1" for lower-case notation, and setting the value of the bit in position 6 of the binary code which represents the final character of the data representation, in other words the least significant element, to the other binary value, in other words the value "0" for upper-case notation.

Clearly, the above information is provided purely by way of example, and accordingly it would be possible to consider the alternative use of an inverse representation of a complete numeric data element, in which the numeric data element is represented by upper-case characters, with the exception of the least significant element, which is represented by a lower-case alphabetic character.

Some examples of numeric representation are shown in the following table, in which the values expressed in different numeric bases are shown in each row.

| Decimal base | Hexadecimal base | Base 26 |
| --- | --- | --- |
| 125 | 7D | eV |
| 23456 | 5BA0 | bisE |
| 2000000000 | 77359400 | gmipnwY |

The number of symbols used is 52, in other words the 26 upper-case letters and the 26 lower-case letters, and thus it is advantageously possible to represent a numeric data element which is self-consistent, in other words one whose size in terms of the number of alphabetic characters or of bits representing the characters of the numeric data element can be deduced from the numeric data element which is represented.

Thus, it is possible to compose the following string, formed by the sequence of four numeric data elements represented in the base 26 coding proposed by the invention: "abcDjxGpBC", using only bits of useful information in the computer's memory registers.

The following values can be readily distinguished:

| Base 26 | Decimal |
|---------|---------|
| abcD | 731 |
| jxG | 6688 |
| pB | 391 |
| C | 2 |

Evidently, therefore, a numeric data element expressed in the chosen base can advantageously be identified without requiring the use of data storage field delimiter characters, in other words characters which are different from (additional to) those forming the representation of the numeric data element and which indicate the boundary between one numeric data element and the next in the representation, and without requiring the a priori definition of the dimensions of a data storage field provided for the representation of numeric data.

Since the upper-case and lower-case notation of the alphabetic characters can be distinguished in the ASCII standard by the value of the bit in position 6 of the binary code representing a character, the recognition of the least significant element in the expression of the numeric data element, and therefore of the complete numeric data element, is easy and rapid, thus permitting the rapid decoding of the information which is carried.

The representation described above can serve as the basis for the implementation of a method for the encoding, and the corresponding decoding, of data structures based on the concatenation of strings adapted to be transmitted as a sequence of characters by a telecommunications system.

The innovative concatenation method comprises, for each string of the data structure to be transmitted, the provision of a useful data field for the representation of a sequence of characters of the string, and a header field associated with it, for indicating a numeric data element representing the number of characters making up the useful data field.

The header field of the string includes a numeric data element represented in the innovative numbering system which has been described, and therefore it has an adapted size which is variable according to the associated string, and more specifically it has a size of one or more bytes, depending on the number of alphabetic characters representing said numeric data element.

In pseudo-code, the fields forming each concatenated string can be represented as:

$$\text{Base26}(\text{len}(\text{String})) + \text{String}$$

where:

"String" is the sequence of characters to be concatenated;

"len(String)" is the numeric data element indicating the number of characters making up the string; and

Base26() is the function which translates a numeric data element in the base 26 coding which has been described.

An example of a concatenated string is:

"G123456HabcdefgbJnel mezzo del cammin di nostra vita"

The concatenated strings are:

| Length in base 26 | Decimal length = number of string characters | String |
|-------------------|----------------------------------------------|--------|
| G | 6 | 123456 |
| H | 7 | abcdefg |
| bJ | 35 | Nel mezzo del cammin di nostra vita |

A computer-implemented method for decoding complex data structures comprising concatenated strings received in the form of a sequence of characters in a telecommunications system comprises:

the reading of the numeric data element of a first header field encoded in the positional numbering system which has been described;

the acquisition of a string in the form of a sequence of characters having the length determined by the value of the numeric data element recognized in the preceding step; and

the iteration of the preceding steps until the character sequence is exhausted.

The following conclusions can be drawn from this example:

- there is no need for a method of stuffing the concatenated strings, since no delimiter symbols are used;
- since the size of the substring is placed at its head, the use of the buffers which have to store it is optimized in the case of streaming decoding;
- since the base 26 representation according to the invention is based on characters which can be represented according to the ASCII standard, of the "printable" type, these characters are transparent for any communication protocol.

A collection of software modules, so-called classes, adapted to perform the representation of a numeric data element according to the method proposed by the invention and for encoding and decoding data structures according to the method proposed by the invention, and stored on disc or accessible on a network, forms an essential library in telecommunications systems for the transmission of messages with an IP protocol between the subsystems making up the monitoring and control systems (MCS) in satellite networks, characterized in that the supervision data must occupy the smallest possible amount of the bandwidth assigned to the "user data" traffic.

Naturally, the principle of the invention remaining the same, the forms of embodiment and details of construction may be varied widely with respect to those described and illustrated, which have been given purely by way of non-limiting example, without thereby departing from the scope of protection of the present invention as defined by the attached claims.

**Claims**

1.  A computer-implemented method for encoding a numeric data element stored in a memory register or location, comprising the operations of:

    - reading the numeric value of said data element, expressed in a predetermined original numbering base;
    - converting the representation of the numeric data element by means of a stored conversion matrix arranged to link symbols of a base of a first original positional numbering system with symbols of a base of a destination positional numbering system,

    **characterized in that** said destination positional number system has base elements formed by alphabetic characters which are represented according to the ASCII standard in binary coding, and
    the method includes the operation of setting the value of the bit in position 6 of the binary code which represents all the characters representing the data element, with the exception of the character assigned to the least significant element, to a first predetermined binary value, and setting the value of the bit in position 6 of the binary code which represents the character assigned to the least significant element to the different binary value.

2.  Method according to Claim 1, in which the predetermined value of the bit in position 6 of the binary code which represents all the characters representing the data element, with the exception of the character assigned to the least significant element, is the value "1", and the value of the bit in position 6 of the binary code which represents the character assigned to the least significant element is the value "0", so that the least significant element of the expression of the numeric data element is an alphabetic character in upper-case notation and the other elements, if present, are alphabetic characters in lower-case notation.

3.  Method according to Claim 1 or 2, in which said alphabetic characters comprise the 26 characters of the English alphabet, which are represented according to the ASCII standard in binary coding and are identified by the decimal codes in the range from 65 to 90 in upper-case form and by the decimal codes in the range from 97 to 122 in lower-case form.

4.  A computer-implemented method for encoding complex data structures, comprising the concatenation of strings for their transmission as a sequence of characters in a telecommunications system,
    **characterized in that**, for each string of the data structure to be transmitted, it comprises:

    - the provision of a header field for the string, associated with a useful data field for the representation of a sequence of characters of the string, in which said header field has a stored data element representing the number of characters which make up the useful data field; and
    - writing into said header field a numeric data element encoded in a positional numbering system whose base elements are alphabetic characters which are represented according to the ASCII standard in binary coding, in which the value of the bit in position 6 of the binary code which represents all the characters representing the data element, with the exception of the character assigned to the least significant element, is set to a first predetermined binary value, and the value of the bit in position 6 of the binary code which represents the character assigned to the least significant element is set to the other binary value.

5. Method according to Claim 4, in which the predetermined value of the bit in position 6 of the binary code which represents all the characters representing the data element, with the exception of the character assigned to the least significant element, is the value "1", and the value of the bit in position 6 of the binary code which represents the character assigned to the least significant element is the value "0", so that the least significant element of the expression of the numeric data element is an alphabetic character in upper-case notation and the other elements, if present, are alphabetic characters in lower-case notation.

6. Method according to Claim 4 or 5, in which said alphabetic characters comprise the 26 characters of the English alphabet, which are represented according to the ASCII standard in binary coding and are identified by the decimal codes in the range from 65 to 90 in upper-case form and by the decimal codes in the range from 97 to 122 in lower-case form.

7. A computer-implemented method for decoding complex data structures comprising concatenated strings received as a sequence of characters in a telecommunications system,
   **characterized in that** each string comprises a header field adapted to store a numeric data element representing the number of characters which make up the string, and a useful data field for representing the sequence of characters of the string,
   and the method comprises:

   i) reading the numeric data element of a first header field encoded in a positional numbering system whose base elements are alphabetic characters represented according to the ASCII standard in binary coding, in which the value of the bit in position 6 of the binary code which represents all the characters representing the data element, with the exception of the character assigned to the least significant element, is set to a first predetermined binary value, and the value of the bit in position 6 of the binary code which represents the character assigned to the least significant element is set to the other binary value;
   ii) acquiring a string as a sequence of characters having the length determined by the value of the numeric data element recognized in step i); and
   iii) iterating the steps i) and ii) until the character sequence is exhausted.

8. Method according to Claim 7, in which the predetermined value of the bit in position 6 of the binary code which represents all the characters representing the data element, with the exception of the character assigned to the least significant element, is the value "1", and the value of the bit in position 6 of the binary code which represents the character assigned to the least significant element is the value "0", so that the least significant element of the expression of the numeric data element is an alphabetic character in upper-case notation and the other elements, if present, are alphabetic characters in lower-case notation.

9. Method according to Claim 7 or 8, in which said alphabetic characters comprise the 26 characters of the English alphabet, which are represented according to the ASCII standard in binary coding and are identified by the decimal codes in the range from 65 to 90 in upper-case form and by the decimal codes in the range from 97 to 122 in lower-case form.

10. Method for the transmission of data organized in complex structures, including the encoding of data structures as a sequence of characters in a transmission apparatus, according to a method defined in Claims 4 to 6, and the decoding of a sequence of characters as data structures in a receiving apparatus, according to a method defined in Claims 7 to 9.

11. Computer system arranged to implement a method for encoding a numeric data element according to Claims 1 to 3.

12. Computer system arranged to implement a method for encoding a data structure according to Claims 4 to 6.

13. Computer system arranged to implement a method for decoding a data structure according to Claims 7 to 9.

14. Computer program or set of programs for implementing a method of encoding a numeric data element according to Claims 1 to 3, a method of encoding a data structure according to Claims 4 to 6, and a method of decoding a data structure according to Claims 7 to 9.